# EUROPEAN PATENT SPECIFICATION

(11) **EP 4 343 261 B1**
(45) Date of publication and mention of the grant of the patent: **02.07.2025**
(21) Application number: 22827081.5
(22) Date of filing: 19.03.2022
(51) Int. Cl.: F28D 15/04, H05K 7/20, F28F 3/04

(54) **EVAPORATOR**
VERDAMPFER
ÉVAPORATEUR

(30) Priority: 22.06.2021 CN 202110694902
(43) Date of publication of application: 27.03.2024
(73) Proprietor: ZTE Corporation, Shenzhen, Guangdong 518057 (CN)
(72) Inventor: LI, Biying, Shenzhen, Guangdong 518057 (CN); SUN, Zhen, Shenzhen, Guangdong 518057 (CN); XU, Qingsong, Shenzhen, Guangdong 518057 (CN)
(74) Representative: Pulieri, Gianluca Antonio
(86) International application number: PCT/CN2022/081857
(87) International publication number: WO 2022/267576

(56) References cited:
- EP-A1- 3 726 572
- EP-B1- 3 594 599
- CN-A- 109 405 608
- CN-A- 111 473 671
- CN-A- 111 595 187
- CN-A- 112 129 147
- CN-A- 112 201 635
- CN-U- 205 482 499
- JP-A- 2011 187 599
- KR-A- 20140 092 543
- TW-A- 200 829 852
- US-A1- 2012 247 736
- US-A1- 2019 162 481
- US-B1- 6 827 134
- US-B2- 10 704 838

## Description

### Technical Field

The present disclosure embodiments relate to the field of communication, and particularly relates to an evaporator.

### Background

As electronic products develop towards higher capacity and better performance, the integration level, functions and power consumption keep increasing accordingly, while the layout becomes more compact. This poses an enormous challenge to the heat dissipation technology. Especially in an air cooling system, a high-power device is likely to suffer shortage of local heat dissipation space. Since a loop thermosyphon device evolved from a traditional thermosyphon tube employs the design of gas-liquid pipeline division, layout of an evaporation zone (an evaporator) and a condensation zone (a condenser) is more flexible and a heat transmission distance is increased. At present, the loop thermosyphon device has been used in some communication network products. It can achieve long-distance heat migration and expand heat dissipation space for large-power devices.

Siphoning is to drive condensate to return to form gas-liquid circulation by gravity. Siphoning devices are suitable for scenes along gravity where an evaporation zone (a heat source) is located below a condensation zone (a heat sink) in a gravity direction. As a lowest gravity level of an entire device, an evaporation surface of an evaporator naturally gathers liquid working media to achieve pool boiling heat transfer. An evaporator according to the preamble of claim 1 is disclosed in EP 3 594 599 B1.

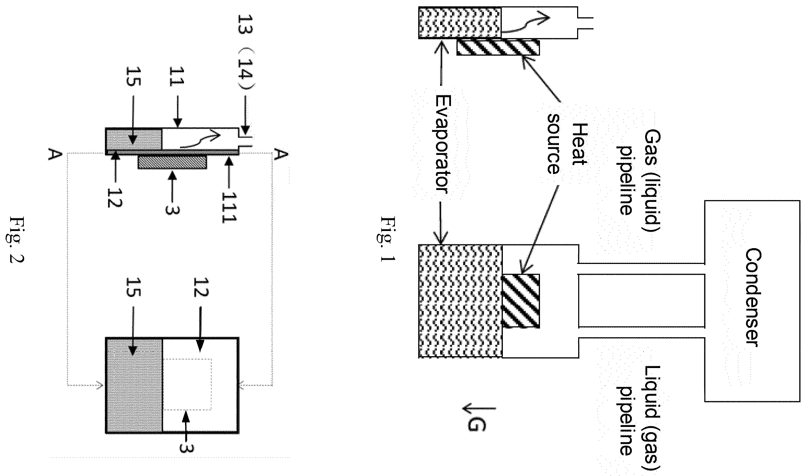

Fig. 1 is a schematic diagram of a loop thermosyphon device of a vertical evaporator in the related art. As shown in Fig. 1, a heat source and a heat sink are far apart in a gravity direction, such that the loop thermosyphon device can exert advantages of long-distance heat migration. However, since a heat source device is in a vertical state, it means that the evaporator also needs to be arranged vertically. Thus, an evaporation surface is not completely at a lowest gravity level, which will lead to some problems as follows:
The heat source cannot be completely covered with liquid working media and becomes partially dried, thereby causing device overheating failure. Simply increasing a filling amount of the working media is not conducive to start and balance of circulation.

A boiling surface is only a liquid level section, such that a space for vapor overflow is narrow, and boiling heat transfer efficiency is low.

In the related art, there is no solution has been proposed to solve problems of how to ensure that the heat source is located in an effective heat transfer zone constantly when the evaporator is in a vertical state and how to improve boiling heat transfer efficiency for the loop thermosyphon device.

### Summary

The embodiments of the invention provide an evaporator, so as to solve problems of how to ensure that a heat source is located in an effective heat transfer zone constantly when an evaporator is in a vertical state and how to improve boiling heat transfer efficiency for a loop thermosyphon device .

The invention is defined by an evaporator according to claim 1. The evaporator is applied to a loop thermosyphon device and includes: a housing 11, a multi-scale structure 12, a gas outlet nozzle 13, a liquid return nozzle 14, and a liquid working medium 15.

The liquid working medium 15 is disposed at a bottom of the housing 11. The gas outlet nozzle 13 is disposed at a top of the housing 11. The liquid return nozzle 14 is disposed at a position except a zone corresponding to a heat source device 3. The multi-scale structure 12 is arranged on an inner wall of a heating surface 111. The heating surface 111 is a surface of the housing 11 making contact with the heat source device 3.

The liquid working medium 15 is configured to absorb heat and then evaporate into gas. The heat is output to a condenser via the gas outlet nozzle 13. The liquid working medium15 is condensed and returned to the bottom of the housing 11 via the liquid return nozzle 14.

In an embodiment, the gas outlet nozzle 13 is disposed in a gravity direction. The gas outlet nozzle 13 is disposed at a position except the zone corresponding to the heat source device 3. The position of the gas outlet nozzle 13 is set to be greater than or equal to a liquid level in height. The liquid level is a liquid level of the liquid working medium 15.

In an embodiment, the multi-scale structure 12 and the inner wall of the heating surface 111 are combined through sintering, cover at least the zone corresponding to the heat source device 3 and extend to the bottom of the housing 11.

In an embodiment, the multi-scale structure 12 includes a core wick 121 and a peripheral wick 122. The core wick 121 is arranged in the zone corresponding to the heat source device 3. The peripheral wick 122 is arranged around the core wick 121.

In an embodiment, the multi-scale structure 12 is configured to generate a capillary force.

The liquid working medium 15 rises to cover a heat input zone corresponding to the heat source device 3 under the action of the capillary force.

In an embodiment, the core wick 121 and the peripheral wick 122 are both made of porous medium materials. The porous medium material of the core wick 121 has a smaller pore size than the porous medium material of the peripheral wick 122.

In an embodiment, the porous medium material includes metal powder or a wire mesh.

According to the invention, the multi-scale structure 12 is a microchannel. The microchannel is formed by machining or etching the inner wall of the heating surface 111.

The liquid return nozzle 14 at a top of the heating surface 111.

In an embodiment, the microchannel includes a liquid division channel 221 and a main channel 222. One end of the liquid division channel 221 is connected to the liquid return nozzle 14, and the other end of the liquid division channel is connected to the main channel 222.

The main channel 222 covers at least the zone corresponding to the heat source device 3 and extends to the bottom of the housing 11.

In an embodiment, the main channel 222 includes a core channel 223. The core channel 223 is disposed in the zone corresponding to the heat source device 3.

The core channel 223 is formed by parallel channels or crossing channels. The core channel 223 has a greater channel density than other zones except the core channel 223. or a channel angle of a partial zone of the core channel 223 adjusts the liquid flow distribution to form a diversion and liquid absorption channel.

In an embodiment, the liquid working medium 15 is configured to be condensed and returned into the housing 11 via the liquid return nozzle 14, and then the liquid working medium 15 is divided into a plurality of flows of liquid along the liquid division channels 221 and flow into the main channel 222 under the action of an adsorption force of the core channel 223, so as to cover a heat input zone corresponding to the heat source device 3.

In an embodiment, the main channel 222 is configured to generate a capillary force for the liquid working medium 15 when a channel width and a channel distance of the main channel 222 satisfy preset conditions, so as to assist in replenishing the heat input zone corresponding to the heat source device 3 with liquid.

According to the evaporator of the embodiments of the disclosure, the liquid working medium 15 is disposed at the bottom of the housing 11, the gas outlet nozzle 13 is disposed at a top of the housing 11, the liquid return nozzle 14 is disposed at any position except the zone corresponding to the heat source, and the multi-scale structure 12 is arranged on the inner wall of the heating surface 111. The heating surface 111 is the surface of the housing 11 making contact with the heat source device 3. The liquid working medium 15 is configured to absorb the heat and then evaporate into gas. The heat is output to the condenser via the gas outlet nozzle 13, and the liquid working medium is condensed and returned to the bottom of the housing 11 via the liquid return nozzle 14. In this way, the problems of how to ensure that the heat source is located in the effective heat transfer zone constantly when the evaporator is in the vertical state and how to improve the boiling heat transfer efficiency for the loop thermosyphon device in the related art can be solved. Designing the multi-scale structure on the inner wall of the heating surface can optimize liquid replenishing performance of the evaporator in a vertical state along gravity, and can ensure that the heat input zone corresponding to the heat source is located in the effective heat transfer zone constantly. Further, the boiling heat transfer efficiency in the zone can be strengthened, such that circulating heat transfer capacity can be improved, advantages of long-distance heat migration along gravity of the loop thermosyphon device can be fully exerted, and technical applicability can be enhanced.

### Brief Description of the Drawings

Fig. 1 is a schematic diagram of a loop thermosyphon device of a vertical evaporator in the related art;
Fig. 2 is a schematic diagram of an evaporator according to an embodiment of the disclosure;
Fig. 3 is a first schematic diagram of an evaporator according to an embodiment;
Fig. 4 is a second schematic diagram of an evaporator according to an embodiment;
Fig. 5 is a third schematic diagram of an evaporator according to an embodiment;
Fig. 6 is a fourth schematic diagram of an evaporator according to an embodiment;
Fig. 7 is a fifth schematic diagram of an evaporator according to an embodiment.

In the figures, 3-heat source device, 11-housing, 12-multi-scale structure, 13-gas outlet nozzle, 14-liquid return nozzle; 15-liquid working medium, 111-heating surface, 121-core wick, 122-peripheral wick, 221-liquid division channel, 222-main channel, 223-core channel.

### Detailed Description of the Embodiments

Embodiments of the disclosure will be described in detail below with reference to the accompanying drawings in conjunction with the embodiments.

It should be noted that the terms such as "first" and "second" in the description and claims of the disclosure and in the above drawings are used to distinguish between similar objects and not necessarily to describe a particular order or sequential order.

An embodiment of the disclosure provides an evaporator. Fig. 2 is a schematic diagram of the evaporator according to the embodiment. As shown in Fig. 2, the evaporator includes: a housing 11, a multi-scale structure 12, a gas outlet nozzle 13, a liquid return nozzle 14, and a liquid working medium 15.

The liquid working medium 15 is disposed at a bottom of the housing 11. The gas outlet nozzle 13 is disposed at a top of the housing 11. The liquid return nozzle 14 is disposed at a position except a zone corresponding to a heat source device 3. The multi-scale structure 12 is arranged on an inner wall of a heating surface 111. The heating surface 111 is a surface of the housing 11 making contact with the heat source device 3.

The liquid working medium 15 is configured to absorb heat and then evaporate into gas. The heat is output to a condenser via the gas outlet nozzle 13. The liquid working medium is condensed and returned to the bottom of the housing 11 via the liquid return nozzle 14.

In An embodiment, the gas outlet nozzle 13 is disposed in a gravity direction. The gas outlet nozzle 13 is disposed at a position except the zone corresponding to the heat source device 3. The position of the gas outlet nozzle 13 is set to be greater than or equal to a liquid level in height. The liquid level is a liquid level of the liquid working medium 15.

In another embodiment, the multi-scale structure 12 and the inner wall of the heating surface 111 are combined through sintering, cover at least the zone corresponding to the heat source device 3 and extend to the bottom of the housing 11.

According to the evaporator in the embodiment, designing the multi-scale structure on the inner wall of the heating surface can optimize liquid replenishing performance of the evaporator in a vertical state along gravity, and can ensure that a heat input zone corresponding to the heat source is located in an effective heat transfer zone constantly. Further, boiling heat transfer efficiency in the zone can be strengthened, such that circulating heat transfer capacity can be improved, advantages of long-distance heat migration along gravity of the loop thermosyphon device can be fully exerted, and technical applicability can be enhanced. The problems of how to ensure that the heat source is located in the effective heat transfer zone constantly when the evaporator is in a vertical state and how to improve the boiling heat transfer efficiency for a loop thermosyphon device in the related art can be solved.

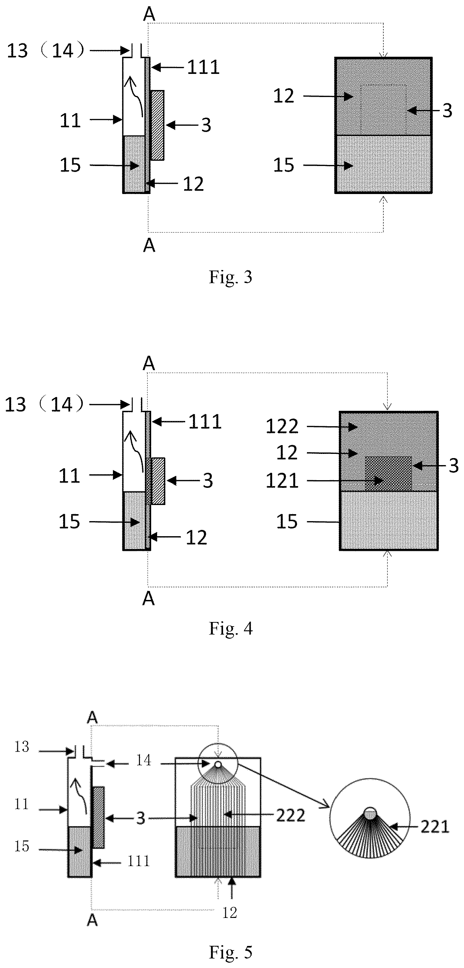

Fig. 3 is a first schematic diagram of an evaporator according to an embodiment. As shown in Fig. 3, the multi-scale structure 12 includes a core wick 121 and a peripheral wick 122. The core wick 121 is arranged in the zone corresponding to the heat source device 3, and the peripheral wick 122 is arranged around the core wick 121.

In an embodiment, the multi-scale structure 12 is configured to generate a capillary force. The liquid working medium 15 rises to cover a heat input zone corresponding to the heat source device 3 under the action of the capillary force.

Fig. 4 is a second schematic diagram of an evaporator according to an embodiment. As shown in Fig. 4, the core wick 121 and the peripheral wick 122 are both made of porous medium materials. The porous medium material of the core wick 121 has a smaller pore size than the porous medium material of the peripheral wick 122. The porous medium material includes metal powder or a wire mesh. That is, the multi-scale structure may be made of a porous medium material. The porous medium material includes metal powder, a wire mesh, etc. The multi-scale structure and the inner wall of the heating surface are combined through sintering, cover at least the zone corresponding to the heat source and extend to a bottom of the evaporator.

Regardless of whether or not the zone is designed differently, the zone corresponding to the heat source is made of the porous medium material having a smaller pore size than other zones, such that a greater capillary force is generated, and the core wick 121 is formed. The liquid working medium condensed and returned by gravity is accumulated at the bottom of the evaporator. Generally, the gas outlet nozzle 13 is disposed at a top of the evaporator and located at a position not lower than a liquid level in a gravity direction except the zone corresponding to the heat source. The liquid return nozzle 14 may be disposed at any position except the zone corresponding to the heat source. The liquid working medium 15 at the bottom of the evaporator may rise to cover the entire heat input zone corresponding to the heat source under the action of the capillary force generated by a wick on the inner wall of the vertical heating surface, absorb the heat, then evaporate into gas, and take the heat out to the condenser via the gas outlet nozzle 13.

Fig. 5 is a third schematic diagram of an evaporator according to an embodiment. As shown in Fig. 5, the multi-scale structure 12 is a microchannel. The microchannel is formed by machining or etching the inner wall of the heating surface 111. The liquid return nozzle 14 is disposed at a top of the heating surface 111. Further, the microchannel includes a liquid division channel 221 and a main channel 222. One end of the liquid division channel 221 is connected to the liquid return nozzle 14, and the other end of the liquid division channel is connected to the main channel 222. The main channel 222 covers at least the zone corresponding to the heat source device 3 and extends to the bottom of the housing 11.

The multi-scale structure is a microchannel 22, and is formed by machining or etching the inner wall of the heating surface. In this case, the liquid return nozzle 24 on the top of the heating surface. The microchannel includes the liquid division channel 221 and the main channel 222. One end of the liquid division channel is connected to the liquid return nozzle, and the other end of the liquid division channel is connected to the main channel. The main channel covers at least the zone corresponding to the heat source and extends to the bottom of the evaporator.

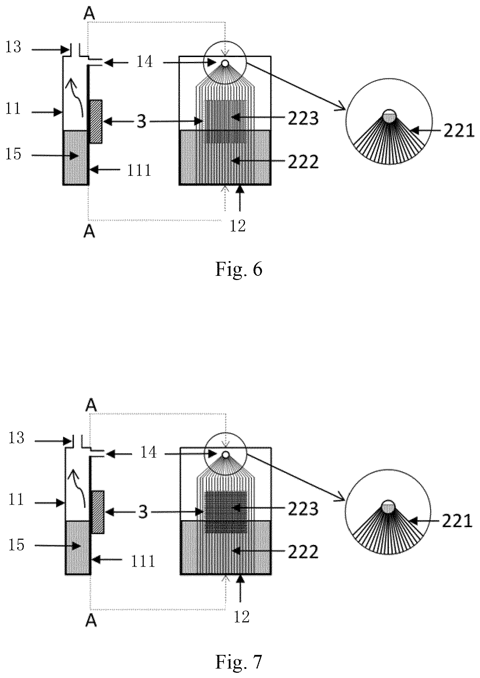

Fig. 6 is a fourth schematic diagram of an evaporator according to an embodiment. As shown in Fig. 6, the main channel 222 includes a core channel 223. The core channel 223 is disposed in the zone corresponding to the heat source device 3. The core channel 223 is formed by parallel channels or crossing channels. The core channel 223 has a greater channel density than other zones except the core channel 223. A channel angle of a partial zone of the core channel 223 adjusts the liquid flow distribution to form a diversion and liquid absorption channel.

In an embodiment, the liquid working medium 15 is configured to be condensed and returned into the housing 11 via the liquid return nozzle 14, and then be divided into a plurality of flows of liquid along the liquid division channels 221 and flow into the main channel 222 under the action of an adsorption force of the core channel 223, so as to cover a heat input zone corresponding to the heat source device 3.

In an embodiment, the main channel 222 is configured to generate a capillary force for the liquid working medium 15 when a channel width and a channel distance of the main channel 222 satisfy preset conditions, so as to assist in replenishing the heat input zone corresponding to the heat source device 3 with liquid.

Fig. 7 is a fifth schematic diagram of an evaporator according to an embodiment. As shown in Fig. 7, the zone corresponding to the heat source uses denser parallel channels or crossing channels than other zones to form the core channel 223. The channel angle of the partial zone adjusts the liquid flow distribution to form the diversion and liquid absorption channel.

After the liquid working medium condensed and returned by gravity enters the evaporator from the liquid return nozzle 14, the liquid working medium is divided into a plurality of flows of liquid along the liquid division channels 221 on the inner wall of the heating surface and flows into the main channel 222 under the action of an adsorption force of a wall surface and the channel, so as to cover the entire heat input zone corresponding to the heat source, absorb the heat, then evaporate into gas, and take the heat out to the condenser via the gas outlet nozzle 13. When scales (channel width and distance) are appropriate, the main channel 222 may further generate a certain capillary force for the liquid working medium 15 accumulated at the bottom of the evaporator, which can assist in replenishing a heat input core zone with liquid.

## Claims

1. An evaporator, applied to a loop thermosyphon device, comprising: a housing (11), a multi-scale structure (12), a gas outlet nozzle (13), a liquid return nozzle (14), and a liquid working medium (15), wherein
the liquid working medium (15)is disposed at a bottom of the housing (11), the gas outlet nozzle (13) is disposed at a top of the housing (11), the liquid return nozzle (14) is disposed at a position except a zone corresponding to a heat source device (3), and the multi-scale structure (12) is arranged on an inner wall of a heating surface (111), wherein the heating surface (111) is a surface of the housing (11) making contact with the heat source device (3), and
the liquid working medium (15) is configured to absorb heat and then evaporate into gas, wherein the heat is output to a condenser via the gas outlet nozzle (13), and the liquid working medium (15) is condensed and returned to the bottom of the housing (11) via the liquid return nozzle (14);
**characterised in that**
the multi-scale structure (12) is a microchannel, wherein the microchannel is formed by machining or etching the inner wall of the heating surface (111); and **in that** the liquid return nozzle (14) is disposed at a top of the heating surface (111).

2. The evaporator according to claim 1, wherein
the gas outlet nozzle (13) is disposed in a gravity direction, the gas outlet nozzle (13) is disposed at a position except the zone corresponding to the heat source device (3), and the position of the gas outlet nozzle (13) is set to be greater than or equal to a liquid level in height, wherein the liquid level is a liquid level of the liquid working medium (15).

3. The evaporator according to claim 1, wherein
the multi-scale structure (12) and the inner wall of the heating surface (111) are combined through sintering, cover at least the zone corresponding to the heat source device (3) and extend to the bottom of the housing (11).

4. The evaporator according to claim 1, wherein
the multi-scale structure (12) comprises a core wick (121) and a peripheral wick (122), the core wick (121) is arranged in the zone corresponding to the heat source device (3), and the peripheral wick (122) is arranged around the core wick (121).

5. The evaporator according to claim 4, wherein
the multi-scale structure (12) is configured to generate a capillary force; and
the liquid working medium (15) rises to cover a heat input zone corresponding to the heat source device (3) under the action of the capillary force.

6. The evaporator according to claim 4 or 5, wherein the core wick (121) and the peripheral wick (122) are both made of porous medium materials, and the porous medium material of the core wick (121) has a smaller pore size than the porous medium material of the peripheral wick (122).

7. The evaporator according to claim 6, wherein the porous medium material comprises metal powder or a wire mesh.

8. The evaporator according to claim 1, wherein
the microchannel comprises a liquid division channel (221) and a main channel (222), one end of the liquid division channel (221) is connected to the liquid return nozzle (14), and the other end of the liquid division channel is connected to the main channel (222); and
the main channel (222) covers at least the zone corresponding to the heat source device (3) and extends to the bottom of the housing (11).

9. The evaporator according to claim 8, wherein
the main channel (222) comprises a core channel (223), wherein the core channel (223) is disposed in the zone corresponding to the heat source device (3); and
the core channel (223) is formed by parallel channels or crossing channels, and the core channel (223) has a greater channel density than other zones except the core channel (223); or a channel angle of a partial zone of the core channel (223) adjusts the liquid flow distribution to form a diversion and liquid absorption channel.

10. The evaporator according to claim 9, wherein
the liquid working medium (15) is configured to be condensed and returned into the housing (11) via the liquid return nozzle (14), and then the liquid working medium (15) is divided into a plurality of flows of liquid along the liquid division channels (221) and flow into the main channel (222) under the action of an adsorption force of the core channel (223), so as to cover a heat input zone corresponding to the heat source device (3).

11. The evaporator according to any one of claims 8-10, wherein
the main channel (222) is configured to generate a capillary force for the liquid working medium (15) when a channel width and a channel distance of the main channel (222) satisfy a preset condition, so as to assist in replenishing the heat input zone corresponding to the heat source device (3) with liquid.

## Patentansprüche

1. Ein Verdampfer, der in einem Loop-Thermosyphon-Gerät eingesetzt wird, bestehend aus: einem Gehäuse (11), einer mehrstufigen Struktur (12), einer Gasauslassdüse (13), einer Flüssigkeitsrücklaufdüse (14) und einem flüssigen Arbeitsmedium (15), wobei
das flüssige Arbeitsmedium (15) ist am Boden des Gehäuses (11) angeordnet, die Gasauslassdüse (13) ist an der Oberseite des Gehäuses (11) angeordnet, die Flüssigkeitsrücklaufdüse (14) ist an einer Position angeordnet, die einer Zone entspricht, die einer Wärmequellenvorrichtung (3) entspricht, und die mehrstufige Struktur (12) ist an einer Innenwand einer Heizfläche (111) angeordnet, wobei die Heizfläche (111) eine Oberfläche des Gehäuses (11) ist, die mit der Wärmequellenvorrichtung (3) in Kontakt steht, und
das flüssige Arbeitsmedium (15) ist so konfiguriert, dass es Wärme absorbiert und anschließend in Gas verdampft, wobei die Wärme über die Gasauslassdüse (13) an einen Kondensator abgegeben wird und das flüssige Arbeitsmedium (15) kondensiert und über die Flüssigkeitsrücklaufdüse (14) zum Boden des Gehäuses (11) zurückgeführt wird; **dadurch gekennzeichnet, dass**
die mehrstufige Struktur (12) ist ein Mikrokanal, wobei der Mikrokanal gebildet wird durch Bearbeitung oder Ätzen der Innenwand der Heizfläche (111); und dadurch, dass
die Flüssigkeitsrücklaufdüse (14) ist an der Oberseite angeordnet.

2. Der Verdampfer nach Anspruch 1, wobei
die Gasauslassdüse (13) ist in Schwerkraftrichtung angeordnet, die Gasauslassdüse (13) ist an einer Position außerhalb der Zone angeordnet, die der Wärmequellenvorrichtung (3) entspricht, und die Position der Gasauslassdüse (13) ist so eingestellt, dass sie größer oder gleich einem Flüssigkeitsstand in der Höhe ist, wobei der Flüssigkeitsstand ein Flüssigkeitsstand des flüssigen Arbeitsmediums (15) ist.

3. Der Verdampfer nach Anspruch 1, wobei
die mehrskalige Struktur (12) und die Innenwand der Heizfläche (111) werden durch Sintern miteinander verbunden, bedecken mindestens den Bereich, der der Wärmequellenvorrichtung (3) entspricht, und erstrecken sich bis zum Boden des Gehäuses (11).

4. Der Verdampfer nach Anspruch 1, wobei
die mehrstufige Struktur (12) umfasst einen Kern-Docht (121) und einen peripheren Docht (122), wobei der Kern-Docht (121) in der Zone angeordnet ist, die der Wärmequellenvorrichtung (3) entspricht, und der periphere Docht (122) um den Kern-Docht (121) herum angeordnet ist.

5. Der Verdampfer nach Anspruch 4, wobei
die mehrstufige Struktur (12) ist so konfiguriert, dass sie eine Kapillarkraft erzeugt; und
das flüssige Arbeitsmedium (15) steigt unter der Wirkung der Kapillarkraft an, um eine Wärmeeintrittszone zu bedecken, die der Wärmequellenvorrichtung (3) entspricht.

6. Verdampfer nach Anspruch 4 oder 5, wobei der Kern-Docht (121) und der periphere Docht (122) beide aus porösen Medienmaterialien bestehen, und das poröse Medienmaterial des Kern-Dochts (121) eine kleinere Porengröße aufweist als das poröse Medienmaterial des peripheren Dochts (122).

7. Verdampfer nach Anspruch 6, wobei das poröse Mediummaterial Metallpulver oder ein Drahtgeflecht umfasst.

8. Verdampfer nach Anspruch 1, wobei
der Mikrokanal umfasst einen Flüssigkeitsteilungskanal (221) und einen Hauptkanal (222), wobei ein Ende des Flüssigkeitsteilungskanals (221) mit der Flüssigkeitsrücklaufdüse (14) verbunden ist und das andere Ende des Flüssigkeitsteilungskanals mit dem Hauptkanal (222) verbunden ist; und
der Hauptkanal (222) umfasst mindestens den Bereich, der der Wärmequellenvorrichtung (3) entspricht, und erstreckt sich bis zum Boden des Gehäuses (11).

9. Der Verdampfer nach Anspruch 8, wobei
der Hauptkanal (222) umfasst einen Kernkanal (223), wobei der Kernkanal (223) in der Zone angeordnet ist, die der Wärmequellenvorrichtung (3) entspricht; und
der Kernkanal (223) wird durch parallele oder sich kreuzende Kanäle gebildet und weist eine höhere Kanaldichte auf als andere Zonen, mit Ausnahme des Kernkanals (223); alternativ kann der Kanalwinkel eines Teilbereichs des Kernkanals (223) die Flüssigkeitsströmungsverteilung so anpassen, dass ein Umleitungs- und Flüssigkeitsabsorptionskanal entsteht.

10. Der Verdampfer nach Anspruch 9, wobei das flüssige Arbeitsmedium (15) ist so konfiguriert, dass es kondensiert und über die Flüssigkeitsrückführdüse (14) in das Gehäuse (11) zurückgeführt wird. Anschließend wird das flüssige Arbeitsmedium (15) in mehrere Flüssigkeitsströme entlang der Flüssigkeitsverteilungskanäle (221) aufgeteilt und strömt unter der Wirkung einer Adsorptionskraft des Kernkanals (223) in den Hauptkanal (222), um eine der Wärmequellenvorrichtung (3) entsprechende Wärmeeinbringungszone abzudecken.

11. Der Verdampfer nach einem der Ansprüche 8-10, wobei der Hauptkanal (222) ist so konfiguriert, dass er eine Kapillarkraft für das flüssige Arbeitsmedium (15) erzeugt, wenn eine Kanalbreite und ein Kanalabstand des Hauptkanals (222) eine vorgegebene Bedingung erfüllen, um die Wärmeaufnahmezone, die der Wärmequellenvorrichtung (3) entspricht, mit Flüssigkeit zu versorgen.

## Revendications

1. Évaporateur, appliqué à un dispositif de thermosiphon en boucle, comprenant: un boîtier (11), une structure multi-échelle (12), une buse de sortie de gaz (13), una buse de retour de liquide (14) et un fluide de travail liquide (15), dans lequel
le fluide de travail liquide (15) est disposé au fond du boîtier (11), le buse de sortie de gaz (13) est disposée au sommet du boîtier (11), le buse de retour de liquide (14) est disposée à une position excluant une zone correspondant à un dispositif de source de chaleur (3), et la structure multi-échelle (12) est disposée sur une paroi interne d'une surface de chauffage (111), dans laquelle la surface de chauffage (111) est une surface du boîtier (11) en contact avec le dispositif de source de chaleur (3), et
le fluide de travail liquide (15) est conçu pour absorber la chaleur, puis s'évaporer en gaz, la chaleur étant transmise à un condenseur par l'intermédiaire de la buse de sortie de gaz (13), et le fluide de travail liquide (15) est condensé et renvoyé au fond du boîtier (11) par l'intermédiaire de la buse de retour de liquide (14);
**caractérisé en ce que**
la structure multi-échelle (12) est un microcanal, dans lequel le microcanal est formé par usinage ou gravure de la paroi interne de la surface chauffante (111); et **en ce que** la buse de retour de liquide (14) est disposée à un sommet de la surface de chauffage (111).

2. Évaporateur selon la revendication 1, dans lequel
le buse de sortie de gaz (13) est disposée dans le sens de la gravité, la buse de sortie de gaz (13) est disposée à une position excluant la zone correspondant au dispositif de source de chaleur (3), et la position de la buse de sortie de gaz (13) est réglée pour être supérieure ou égale à un niveau de liquide en hauteur, le niveau de liquide étant un niveau de liquide du fluide de travail liquide (15).

3. Évaporateur selon la revendication 1, dans lequel
la structure multi-échelle (12) et la paroi interne de la surface de chauffage (111) sont combinées par frittage, recouvrant au moins la zone correspondant au dispositif de source de chaleur (3) et s'étendant jusqu'au fond du boîtier (11).

4. Évaporateur selon la revendication 1, dans lequel
la structure multi-échelle (12) comprend une mèche centrale (121) et une mèche périphérique (122), la mèche centrale (121) est disposée dans la zone correspondant au dispositif de source de chaleur (3), tandis que la mèche périphérique (122) est disposée autour de la mèche centrale (121).

5. Évaporateur selon la revendication 4, dans lequel
la structure multi-échelle (12) est configurée pour générer une force capillaire; et
le fluide de travail liquide (15) s'élève pour couvrir une zone d'entrée de chaleur correspondant au dispositif de source de chaleur (3) sous l'action de le force capillaire.

6. Évaporateur selon la revendication 4 ou 5, dans lequel la mèche centrale (121) et la mèche périphérique (122) sont toutes deux constituées de matériaux poreux, et le matériau poreux de la mèche centrale (121) présente une taille de pores inférieure à celle du matériau poreux de la mèche périphérique (122).

7. Évaporateur selon la revendication 6, dans lequel le matériau du milieu poreux comprend de la poudre métallique ou un treillis métallique.

8. Évaporateur selon la revendication 1, dans lequel
le microcanal comprend un canal de division de liquide (221) et un canal principal (222), une extrémité du canal de division de liquide (221) étant connectée à la buse de retour de liquide (14), et l'autre extrémité du canal de division de liquide étant connectée au canal principal (222); et
le canal principal (222) couvre au moins la zone correspondant au dispositif de source de chaleur (3) et s'étend jusqu'au fond du boîtier (11).

9. Évaporateur selon la revendication 8, dans lequel
le canal principal (222) comprend un canal central (223), dans lequel le canal central (223) est disposé dans la zone correspondant au dispositif de source de chaleur (3); et
le canal central (223) est constitué de canaux parallèles ou croisés, et présente une densité de canaux supérieure à celle des autres zones, à l'exception du canal central (223); ou l'angle d'une zone partielle du canal central (223) ajuste la distribution de l'écoulement du liquide pour former un canal de déviation et d'absorption du liquide.

10. Évaporateur selon la revendication 9, dans lequel
le fluide de travail liquide (15) est configuré pour être condensé et renvoyé dans le boîtier (11) par l'intermédiaire de la buse de retour de liquide (14); ensuite, le fluide de travail liquide (15) est divisé en une pluralité de flux de liquide le long des canaux de division de liquide (221) et s'écoule dans le canal principal (222) sous l'action d'une force d'adsorption du canal central (223), de manière à couvrir une zone d'entrée de chaleur correspondant au dispositif de source de chaleur (3).

11. Évaporateur selon l'une quelconque des revendications 8 à 10, dans lequel
le canal principal (222) est configuré pour générer une force capillaire pour le fluide de travail liquide (15) lorsque la largeur et la distance du canal principal (222) satisfont à une condition prédéfinie, de manière à faciliter le réapprovisionnement en liquide de la zone d'entrée de chaleur correspondant au dispositif de source de chaleur (3).
